# EUROPEAN PATENT SPECIFICATION

(11) **EP 2 841 503 B1**
(45) Date of publication and mention of the grant of the patent: **29.08.2018**
(21) Application number: 13719532.7
(22) Date of filing: 26.04.2013
(51) Int. Cl.: C08L 77/00, H01B 1/02, B32B 15/088, H05K 3/12, C09D 11/00

(54) **ELECTRICALLY CONDUCTIVE POLYAMIDE SUBSTRATE**
ELEKTRISCH LEITFÄHIGES POLYAMIDSUBSTRAT
SUBSTRAT EN POLYAMIDE ÉLECTROCONDUCTEUR

(30) Priority: 27.04.2012 EP 12165949
(43) Date of publication of application: 04.03.2015
(73) Proprietor: DSM IP Assets B.V., 6411 TE Heerlen (NL)
(72) Inventor: BURGT VAN DER, Frank Peter Theodorus Johannes, NL-6100 AA Echt (NL); SCHRÖDER, Christiaan, NL-6100 AA Echt (NL)
(74) Representative: DSM Intellectual Property
(86) International application number: PCT/EP2013/058749
(87) International publication number: WO 2013/160454

(56) References cited:
- WO-A1-2007/038950
- US-A1- 2005 133 823
- US-A1- 2010 078 209
- ALEXANDER KAMYSHNY: "Metal-based Inkjet Inks for Printed Electronics", THE OPEN APPLIED PHYSICS JOURNAL, vol. 4, no. 1, 24 March 2011 (2011-03-24), pages 19-36, XP055040642, ISSN: 1874-1835, DOI: 10.2174/1874183501104010019 cited in the application

## Description

The invention relates to an electrically conductive system comprising a substrate and an electrically conductive track adhered to the substrate.

Conductive tracks are generally applied to a substrate by a process referred to as Laser Direct Structuring (LDS). Such a process is described for example in EP1274288. During this process, non-conductive heavy metal complexes are incorporated into the substrate material, after which the substrate is moulded. Thereafter the substrate is irradiated with a laser beam in the pattern of the conductive tracks to be construed. As a result of the laser irradiation the surface is activated and metal seeds are generated and exposed on the surface of the substrate. The exposed metal seeds are metalized by chemical reduction in the following steps. Generally the tracks are built up in electroless plating baths with copper to form layers of 2,5 to 15 µm thick, electroless nickel (1-2,5 µm), followed by plating with silver and/or gold (0,05- 0,2 µm). After each plating bath, several rinsing cycles are needed before the following plating step can be started. This process leads to the formation of metalized, conductive tracks along the pattern that the laser beam has followed.

A disadvantage of such an LDS-process is that the plating step is very critical and requires a lot of attention and control of the concentration and quality of the individual components, including sodium hydroxide, formaldehyde, chelate, and copper along with several reaction stabilizers. Clearly this process step requires a lot of knowledge and continuous attention. Additionally, the chemicals used in these baths and the waste streams generated, make the process from an environmentally point of view very unattractive and are therefore under debate. The electrically conductive systems produced with this process are therefore not very environmentally friendly. Further the apparatus needed in the LDS-process is expensive. Another disadvantage of the LDS- systems is that the product contains nickel to which many people develop or already show allergic reactions.

Therefore a need exists for electrically conductive systems whose production is less environmentally unfriendly. A process to produce those conductive systems was developed and is described for example by Kamyshny et al in "The Open Applied Physics Journal", 2011, 4, 19-36. The process comprises the printing of the electrical circuitry with metal-base inks in an inkjet printing process. During this process droplets of ink are jetted from a small orifice in a printhead, directly to a specified position on a substrate. In contrast to normal home/ office-use, the inks used in the printing of electronic circuitry are metal-based, more specifically the inks contain metal nanoparticles, complexes or metallo-organic compounds. The ink-jet printing step is generally followed by a sintering process to obtain conductivity in the tracks. Although the electrically conductive systems that are produced via such an inkjet printing- based technique are less environmentally unfriendly, they suffer from the disadvantage that they do not provide with all kinds of substrates, electrically conductive systems with the required level of adhesion between the substrate and the conductive track.

Currently most solutions to overcome this disadvantage consist of providing new types of inks, but these solutions can be quite complex. Very little effort has been directed towards providing alternative substrates that could increase adhesion between substrate and the electrically conductive track.

Therefore a need exists for electrically conductive systems whose production is less environmentally unfriendly while these systems still meet the requirements, especially with respect to the adhesion between the substrate and the conductive track. It is the object of the present invention to provide these systems and overcome, or at least reduce, the disadvantages of the prior art.

This object has surprisingly been reached by an electrically conductive system comprising a substrate and an electrically conductive track adhered to the substrate, wherein the substrate comprises a semi-aromatic polyamide and the electrically conductive track is obtained by jet printing according to claim 1. Herein, the substrate is obtained by melt processing of a composition comprising a semi-aromatic polyamide;
- the substrate comprises at least 30 wt.% of the semi-aromatic polyamide,
- the semi-aromatic polyamide comprises repeat units derived from diamines and repeat units derived from dicarboxylic acids, and
- at least 10 mole% relative to the total molar amount of diamines and dicarboxylic acids consists of aromatic diamines or aromatic dicarboxylic acids.

It has been found that the electrically conductive system according to the invention comprising the semi-aromatic polyamide substrate results in a good level of adhesion between the substrate and the conductive track as determined by the so-called "cross hatching test", according to ASTM D3359-08 D, test method B.

Thus the present invention provides an electrically conductive system as described above, wherein the adhesion between the substrate and electrically conductive track has classification 4B or 5B according to ASTM D3359-08 D, test method B.

As will be shown later, it is surprising that the semi-aromatic polyamide substrate provides such good adhesion since other high performance polymers, such as liquid crystal polymer, LCP, fail in the adhesion test. Moreover, the semi-aromatic polymer according to the invention is able to withstand the relatively high sintering temperatures of above 200 °C.

Also, even after exposure to high humidity and high temperature conditions for a prolonged period of time, the adhesion remains high. This makes the electrically conductive system particularly suitable for certain applications in electronic equipment, such as antennae for mobile devices.

A further advantage of the electrically conductive system that is prepared with a jet printing process according to the invention is that the height of the conductive track can be lower than with an electrically conductive system that is applied via an LDS-process. Generally a height of approximately a few µm is sufficient when silver is used as the material for the conductive track in an ink- jet based process, while the track height obtained in the LDS-process is generally at least 15- 20 µm. A lower height of the tracks means that less precious metal or metal alloy is needed in the preparation, therefore the costs of the total electrically conductive system is reduced compared to prior art systems.

According to the invention the substrate comprises a semi-aromatic polyamide. Thus the substrate may also comprise other components or polymers. However, the substrate comprises at least 30 wt.% of the semi-aromatic polyamide, based on the total weight of the substrate, preferably at least 40 wt.%

In particular the invention provides an electrically conductive system, wherein the substrate consists of
(A) 30 - 100 wt.% of the semi-aromatic polyamide,
(B) 0 - 50 wt.% of a at least one other polymer
(C) 0 - 60 wt.% of reinforcing agents
(D) 0 - 15 wt.% of at least one additive.

Beside the semi-aromatic polyamide the substrate may also comprise other polymers. A preferred further polymer is an aliphatic polyamide. However, in order to obtain the advantages of the invention, the amount of aliphatic polyamide is at most 50 wt.%, based on the total weight of the substrate. Preferaby the amount of aliphatic polyamide is at most 40 wt.%, based on the total weight of the substrate. The aliphatic polyamide should be compatible with the semi-aromatic polyamide. Examples of aliphatic polyamides are homopolyamides such as polyamide (PA) 6, PA11 or PA12 or copolyamides such as PA46, PA66, PA69, PA610, PA612 and PA1212.

The semi-aromatic polyamide according to the invention preferably has a relatively elevated melting temperature Tm. Thus the melting temperature is at least 250 °C, preferably at least 270 °C. There is no particular upper limit to Tm, although in practice, Tm will be at most 350 °C.

The semi-aromatic polyamide according to the invention preferably comprises repeat units derived from diamines and repeat units derived from dicarboxylic acids, wherein at least 10 mole% relative to the total molar amount of diamines and dicarboxylic acids consists of aromatic diamines or aromatic dicarboxylic acids.

The aromatic dicarboxylic acids can be selected from terephthalic acid, naphthalene dicarboxylic acid, isophthalic acid and mixtures thereof. Examples of aromatic diamines are phenylene diamine and xylylene diamine.

Examples of suitable semi-aromatic polyamides include homopolyamides like PA6T, PA7T, PA9T, PA10T and PA12T having a melting temperature in the range of 270-350 °C, and copolyamides of PA4T, PA5T, PA6T and /or PA8T, with for example PA7T, PA9T, PA10T, PA 11T PA12T, PA6, PA66, and/or PMXD6. Suitable copolyamides include PA 6/6T, PA6I/6T, PA106/10T, PA66/6T, PA46/4T, PA10T/6T, PA9T/M8T, PA6T/5T, PA6T/M5T and PA6T/10T. The polyamides may comprise other repeat units of other diamines and diacids, next to those mentioned in the copolyamides hereabove, thus forming more complex copolyamides. For further examples of suitable semi-aromatic copolyamides see Kunststoff Handbuch, (Carl Hanser Verlag 1998) Band 3/4 Polyamide chapter 6.

A preferred semi-aromatic polyamide according to the invention comprises units derived from aliphatic diamines and units derived from dicarboxylic acids, wherein
- the dicarboxylic acids consist of a mixture of 5-65 mole% aliphatic dicarboxylic acid and optionally aromatic dicarboxylic acid other than terephthalic acid, and 35-95 mole % terephthalic acid;
- the diamines are aliphatic diamines and consist a mixture of 10-70 mole% of a short chain aliphatic diamine with 2-5 C atoms and 30-90 mole % of a long chain aliphatic diamine with at least 6 C atoms;
- the combined molar amount of terephthalic acid and the long chain aliphatic diamine is at least 60 mole %, relative to the total molar amount of the dicarboxylic acids and diamines.

Preferably the short chain aliphatic diamine is selected from the group consisting of ethylene diamine, 1,4-butanediamine and 1,5-pentanediamine, and mixtures thereof. Preferably the long chain aliphatic diamine is selected from the group consisting of hexane diamine, 2-methyl-,1,5-pentanediamine, C8-diamine, C9-diamine, 2-methyl-,1,8-octanediamine, C10-diamine, C11-diamine, C12-diamine and mixtures thereof. Preferably the aliphatic dicarboxylic acid is selected from the group consisting of adipic acid (C6), suberic acid (C8), sebacic acid (C10), dodecanoic acid (C12) and mixtures thereof.
Examples of such semi-aromatic polyamides are described in WO2007/085406.

It has also been found that the molecular weight of the polyamide used as the substrate in the present invention can influence the final properties, especially the adhesion strength. The molecular weight as used here is the number average molecular weight and is determined by gel permeation chromatography. The number average molecular weight (Mn) referred to herein is determined by size-exclusion chromatography (SEC) combined with different detectors. The SEC-system consisted of three PFG Linear XL columns (300 mm x 8 mm ID) supplied by Polymer Standards Service, operating at 0.4 ml/min and thermostatted at 35°C. For the measurements a refractive index detector (RI), a viscometer and a right-angle laser-light scattering detector were used and the molar mass was calculated using these triple detector signals to yield molar-mass. The injection volume was 75 µl. Hexafluoroisopropanol with 0.1 % (w/w) potassium trifluoro-acetate was used as eluent. All samples were filtered over a 0.1 µm filter before injection.

Preferably the number average molecular weight, Mₙ, is less than 9000 g/mol. Preferably the molecular weight Mₙ is at least 2000 g/mol, more preferably the molecular weight Mₙ is between 3000 and 7500 g/mol. For semi-aromatic polyamides the preferred range for the molecular weight is between 3200 and 7000 g/mol. Especially for semi-aromatic polyamides a too low molecular weight can result in a substrate which is relatively brittle, therefore it is preferred for semi-aromatic polyamides for use in the invention to have a molecular weight, determined as Mₙ, of at least 3200 g/mol, preferably at least 3500 g/mol.

The substrate can also contain one or more reinforcing agents, preferably fibrous reinforcing agents. Examples of fibrous reinforcing agents are graphite fiber, carbon fiber, glass fiber, silica fiber, aluminum silicate fiber, processed mineral fiber, phosphate fiber, calcium sulfate fiber or potassium titanate fiber. Preferably, the reinforcing agents are selected from graphite fiber, carbon fiber, glass fiber and combinations thereof. The amount of reinforcing agent that is present in the substrate can be chosen between wide ranges. The amount is generally determined based on the mechanical properties, such as for example the stiffness that an envisaged application requires; the man skilled in the art knows what range of stiffness applies for which application. For example for an application in stiffeners and enclosures a range of 0-60 wt%, preferably 20- 50 wt%, can be added. For an application in add-on and screw-on components a generally applicable range is 0-25wt%. The mentioned weight percentages for the amount of reinforcing agent are relative to the total composition of the subtrate.

The substrate in the electrically conductive system according to the invention can contain only the semi-aromatic polyamide referred to above, however it is also possible to incorporate into the substrate, next to the polyamide and the optionally added one or more reinforcing agents further additives. One type of additives are one or more black pigments. Suitable examples of black pigments are carbon black, graphite, nigrosine or CuCr₂O₄. It is also possible to use a combination of black pigments. The amount of black pigment that is present in the substrate can be chosen between wide ranges. A suitable range for the amount of black pigment is between 0.1-2 wt%, preferably 0.2-0.7 wt%, more preferably 0.3-0.5 wt% relative to the total composition of the substrate. The man skilled in the art of compounding is familiar with the techniques and possibilities for adding and blending several components into a polymeric base material. The mentioned black pigment can for example be added to the polyamide in the form of a masterbatch. The carrier polymer used to introduce the black pigment to the polyamide is not particularly critical. A suitable carrier polymer is for example another type of polyamide, such as for example polyamide-6 (PA6). An especially advantageous substrate for use in the present invention contains next to the polyamide both the fibrous reinforcing agent and the black pigment.

Other examples of additives are fillers, flame retardants, sizing agents, non-electrically conducting additives and auxiliary additives. With auxiliary additives is meant those additives that are known to the person skilled in the art of making polyamide moulding compositions to be usually comprised in said polyamide composition. Auxiliary additives can for example be UV stabilizers, heat stabilizers, antioxidants, colorant processing aids and impact modifiers. The amount of these other components that may be present next to the polyamide may vary over a wide range, but is suitably is in the range of 0-10 wt% relative to the total weight of the composition. Preferably the amount of other components is 0.5-5 wt%, more preferably 0.5-3 wt%.

The composition out of which the substrate according to the invention is made, can be prepared by a process wherein the semi-aromatic polyamide, the optional reinforcing agent, the optional black pigment and the optional other component are melt-blended. Part of the materials may be mixed in a melt-mixer, and the rest of the materials may then be added and further melt-mixed until uniform. Melt-blending may be carried out using any appropriate method known to those skilled in the art. Suitable methods may include using a single or twin-screw extruder, blender, kneader, Banbury mixer, moulding machine, etc. Twin-screw extrusion is preferred, particularly when the process is used to prepare compositions that contain additives such as flame retardants, and reinforcing agents.

The substrate itself can be shaped by means of conventional moulding techniques, e.g. by means of melt processing, depending on the use of the final electrically conductive system. The final shape can be three dimensional, such as an enclosure for an electronic device, but it can also be two dimensional, e.g. a flat plaque or film of material.

According to one aspect of the invention, the substrate has the shape of a thin film, e.g. a film with a thickness of 0.5 to 1000 µm, preferably 5 to 100 µm.

The electrically conductive system comprises next to the substrate at least one conductive track adhered onto the substrate. The conductive track is formed on the substrate by a process that comprises at least the following steps:
- providing a substrate composed of at least one polyamide,
- optionally pre-treating the substrate,
- applying a conductive track precursor on the substrate by a jet printing technique,
- sintering the conductive track precursor on the substrate at an elevated temperature so as to obtain a conductive track on the substrate,
- cooling down the substrate with the conductive track.

The material of which the conductive track is made can be rather freely chosen as long as they provide good electrical conductivity of the printed conductive track. The material for the conductive track is generally a metal or metal alloy. Examples of suitable materials for the conductive track are silver (Ag), copper (Cu), gold (Au), palladium (Pd), platinum (Pt), nickel (Ni) and aluminum (Al) and any combination of two or more of them. Preferably the material is Ag, Cu, Ni or Au or any combination of two or more of them. More preferably the material is Ag.

The ink will contain the metal or its precursor in a suitable liquid carrier. The suitable liquid carrier can for example be water or an organic solvent. The metal or its precursor will generally be available in the ink in a dispersed or dissolved state. A preferred state is the form of a nanoparticle. With nanoparticle is meant a particle with at least one of its dimensions in the nanometer range. A preferred material for use as the conductive track is nano- silver. With "nano-silver" is meant a silver particle of which at least one of its dimensions lies in the nanometer range. The man skilled in the art of jet printing inks for preparing conductive tracks knows how to prepare and handle these kinds of metals and/ or their precursors. Inks for jet printing techniques are for example described in the book "The chemistry of inkjet inks", edited by S. Magdassi, World Scientific Publishing UK, November 2008.

The conductive track precursor is applied with a jet printing technique. Examples of suitable jet printing techniques are ink jet printing and aerosol jet printing. The technique of aerosol jet printing is well-known and is for example described in the article "3D aerosol jet printing- adding electronics functionality to RP/RM" by Martin Hedges et al. presented at the DDMC 2012 Conference held on 14-15 March 2012 in Berlin.

Thus, the invention also relates to a process for the production of an electrically conductive system comprising a substrate and a conductive track adhered to the substrate, comprising the steps of:
- providing a substrate comprising a semi-aromatic polyamide,
- applying a conductive track precursor on the substrate by a jet printing technique,
- sintering the conductive track precursor on the substrate at a temperature of at least 150 °C so as to obtain a conductive track on the substrate.

The conductive track is formed from the conductive track precursor after sintering of the applied ink so as to obtain a continuous connectivity. With sintering is here and hereinafter meant a process of welding the conductive track precursor particles together at a temperature below its melting point. Sintering can be effected by thermal sintering, photonic sintering, microwave sintering, plasma sintering, electrical sintering or sintering by chemical agents. The man skilled in the art of applying conductive tracks is familiar with these techniques and knows how to determine the best method for each case. If thermal sintering is used, preferred temperatures are at least 150°C, preferably at least 180 °C, more preferably at least 200 °C. Maximum temperatures are determined by the thermal degradation of the materials used. In general the temperature will be at most 350 °C. A suitable sintering process can take place at a temperature between 150 and 300 °C for 10- 30 minutes.

The electrically conductive system according to the present invention has surprisingly good adhesion between the substrate and the conductive track. The adhesion between the substrate and the conductive track can be determined by applying the method as described in the Standard Test for Measuring Adhesion by Tape Test, ASTM D3359-08 D, method B, as described below.

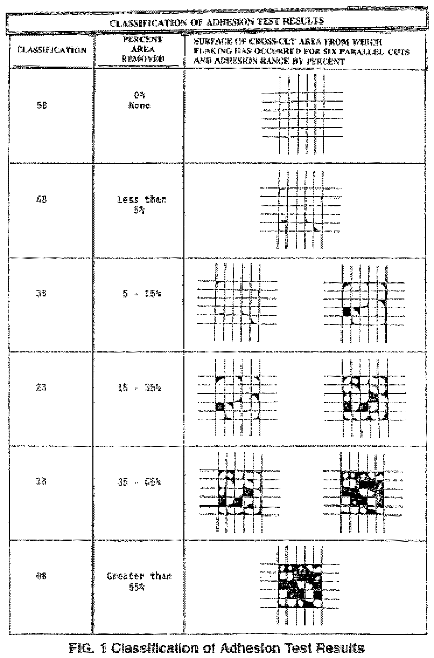

Figure 1 provides the Classification of the Adhesion Test results according to this method.

Depending on the application in which the electrically conductive system will be used, a suitable semi-aromatic polyamide composition will be determined and prepared. Part of this semi-aromatic polyamide composition can be other components than polyamide, for example one or more fibrous reinforcing agents, carbon black and/or other components. All of these components for the polyamide composition are described above and what is described there also applies here. The polyamide composition is made into a substrate by one or more processes well-known to the man skilled in the art of making polymeric substrates.

The substrate can be pre-treated before it is used in the process for the production of an electrically conductive system; however it is also possible to use the substrate without further pre-treatment steps. An example of a pre-treatment could be a cleaning step or a plasma- treatment.

In a next step the conductive track precursor is applied onto the substrate by an jet printing technique. The exact nature of the conductive track precursor will depend on the type and required properties of the conductive track.

The final thickness of the conductive track will vary depending on the application. In general the thickness is between 10 nm and 100 µm, preferably between 0.5 µm and 10 µm. It is also possible to apply the conductive track in several consecutive layers, with a sintering and cooling step between each application of the layers.

The invention also relates to the use of an electrically conductive system according to the invention. As the adhesion of the electrically conductive system on the substrate is improved compared to prior art systems new application areas become available next to the previously known applications. An example of an advantageous application is in antennas, such as for example in mobile devices, e.g. phones. It was previously impossible with the then available techniques, such as laser direct structuring, to produce an antenna on a substrate with carbon fiber in it.

Further applications include electrical circuits and connectors that can be used in a variety of objects, e.g. in solar cells, transistors, OLED's and RFID technologies. If the substrate is a film, the electrically conductive system of the invention is particularly suitable for flexible printed circuits (FPC).

The invention will be demonstrated in the following examples.

### Examples

### Methods

### Adhesion

In order to determine adhesion of the printed coating on the substrate, ASTM test ASTM D3359-08 D: "Standard Test Methods for Measuring Adhesion by Tape Test" is applied. According to test method B, a lattice pattern with six cuts in each direction is made in the coating to the substrate. Pressure-sensitive tape is applied over the lattice. The tape is peeled away at an angle of 180° with constant speed and force. The adhesion is evaluated according to the Classification of Adhesion Test Results (see Figure 1) and Table 1 below. For further detail the ASTM standard is referred to.

**Table 1**

| **Classification** | **Percent area removed** |
|---|---|
| 5B | 0% (none) |
| 4B | Less than 5% |
| 3B | 5-15% |
| 2B | 15-35% |
| 1B | 35-65% |
| 0B | Greater than 65% |

### Viscosity: Relative viscosity (RV)

The measurement of the relative viscosity (RV) was performed according to ISO 307, fourth edition. For the measurements pre-dried polymer samples were used the drying of which was performed under high vacuum (i.e. less than 50 mbar) at 80°C during 24 hrs. Determination of the relative viscosity was done at a concentration of 1 gram of polymer in 100 ml solvent at at 25,00 ± 0,05 °C.

### DSC measurements: Tg and Tm

The melting temperature (Tm) of the polymer was measured according to ASTM D3418-03 by DSC in the second heating run with a heating rate of 10°C/min.

The glass transition temperature (Tg) of the polymer was measured according to ASTM E 1356-91 by DSC in the second heating run with a heating rate of 10°C/min, falling in the glass transition range and showing the highest glass transition rate.

### Materials used

### Polymers

P1 Polyamide 6T/4T/66, semi aromatic polyamide, Tm 325°C, Tg 125°C, RV 1.9 obtainable under the trade name Stanyl® ForTii from DSM Engineering Plastics
P2 Polyamide 6T/4T/66, semi aromatic polyamide, Tm 325°C, Tg 125°C, RV 2.1 obtainable under the trade name Stanyl® ForTii from DSM Engineering Plastics
P3 Polyamide 6T, semi aromatic polyamide, Tm 260°C, Tg 110°C, obtainable under the trade name HTN53 from Dupont
P4 Polyamide 6I/6T/66, Tm 260°C, Tg 110°C obtainable under the tradename Grivory GVX from EMS
P5 Polyamide 46 obtainable under the tradename Stanyl ® from DSM Engineering Plastics
P6 Polyamide 6, obtainable under the tradename Akulon®, from DSM Engineering Plastics
P7 Polycarbonate, obtainable under the tradename Xantar from Mitsubishi Engineering Plastics
P8 Liquid Crystal Polymer (LCP), obtainable under the tradename Vectra® from Ticona
P9 Polyethylene Terephthalate (PET), obtainable under the tradename Arnite® from DSM Engineering Plastics

For the glass fibers, standard spherical glass fibers were used. For the flame retardant, a halogen free flame retardant, obtainable under the trade name Exolit was used.

### Examples 1 to 9 and Comparative Examples 1 to 5

A plaque molded from the polymer composition, including flame retardant and glass fibers as listed in Table 2 below was prepared, using standard preparation techniques. Molding was performed by using a common injection molding machine with barrel heating conditions ranging from 275-345 °C and with tool temperatures varying between 80 °C and 140 °C. Drops of a silver ink composition (ink based on nanosilver particles less than 10 µm, polyvinyl pyrolidon, glycerine, available under the trade name Cabot CSD66) were dropped on the plaque surface. The ink was spread by means of a Mayer bar to obtain a layer thickness of 5 µm.

Thereafter the plaques were sintered in an oven at 230 °C (unless otherwise indicated in Table 2) for 15 minutes. The adhesion was tested by means of the Adhesion test described above. The results are indicated in Table 2 below as "Adhesion result dry".

A second plaque coated with silver ink was prepared as described above. After sintering, the plaque was submitted to a damp heat treatment as follows. The plaque was placed in an oven at a relative humidity of ca. 95% and submitted to the following temperature cycle: the temperature was gradually increased in 1.5 hours to 65 °C. The plaque was maintained at 65°C for 4 hours. Then the temperature was gradually decreased to 30 °C in 1.5 hours. The temperature was maintained at 30 °C for 1 hour. This 8 hour cycle was repeated 8 times (total 72 hours). Thereafter the oven temperature was set at +25°C and relative humidity of 50% and the plaques were maintained there for 2 hours. The adhesion of the plaques thus treated was tested by means of the adhesion test described above. The results are indicated in Table 2 below as "Adhesion result wet".

**Table 2**

| **Example** | **Polymer composition wt.%** | **Glass fibers wt.%** | **Flame retardant wt.%** | **Adhesion result dry** | **Adhesion result wet** |
|---|---|---|---|---|---|
| 1 | P2 60 | 40 | 0 | 5B | 5B |
| 2 | P1 48 | 40 | 12 | 5B | 5B |
| 3 | P1 40 | 50 | 0 | 5B | 5B |
| | P4 10 | | | | |
| 4 | P2 50 | 40 | 0 | 5B | 5B |
| | P4 10 | | | | |
| 5 | P3 40 | 50 | 10 | 5B | 5B |
| 6 | P4 40 | 50 | 10 | 5B | 4B |
| 7 | P1 100 | 0 | 0 | 5B | 5B |
| 8 | P1 85 | 0 | 0 | 5B | 5B |
| | P4 15 | | | | |
| 9 | P1 70 | 0 | 0 | 5B | 5B |
| | P4 30 | | | | |

| Comparative Example | | | | | |
|---|---|---|---|---|---|
| CE1 | P5 100 | 0 | 0 | 5B | 1B |
| CE2¹ | P6 70 | 30 | 0 | 5B | 0B |
| CE3² | P7 100 | 0 | 0 | 5B | 0B |
| CE4 | P8 60 | 40 | 0 | 5B | 1B |
| CE5 | P9 55 | 45 | 0 | 4B | 2B |

| | | | | | |
|---|---|---|---|---|---|
| ¹ Sintering temperature 200 °C ² Sintering temperature 150 °C | | | | | |

The results in Table 2 show that both the initial adhesion and the adhesion after treatment in humid conditions was very good for the polymer compositions according to the inventions. For the polymers in the comparative examples, results were insufficient. It is also seen from these examples that addition of glass fibers or flame retardant does not alter the results observed.

### Example 10

A plaque was molded and coated with silver ink according to example 3. The plaque was submitted to different sintering temperatures and then the dry and wet adhesion was tested. The results are shown in Table 3.

**Table 3**

| **Sintering Temperature °C** | **Adhesion result dry** | **Adhesion result wet** |
|---|---|---|
| 200 | 5B | 3B |
| 215 | 5B | 4B |
| 230 | 5B | 5B |
| 240 | 5B | 5B |
| 260 | 5B | 5B |
| 280 | 5B | 5B |
| 300 | 5B | 5B |

This table shows that the optimal sintering temperature in this example is above 215 °C.

### Example 11

A plaque molded from the polymer composition as listed in Table 2 according to example 3 was prepared, using standard preparation techniques. Molding was performed by using a common injection molding machine with barrel heating conditions ranging from 275-345 °C and with tool temperatures varying between 80 °C and 140 °C. Drops of a silver ink composition (ink based on nanosilver particles less than 10 µm, polyvinyl pyrolidon, glycerine, available under the trade name Cabot CSD66) were printed on the surface of the plaque using an aerosol ink jet printer. The plaque was submitted to different sintering temperatures between 230 and 300 °C and then the dry and wet adhesion was tested. For all sinter temperatures both dry and wet adhesion was established in category 5B.

## Claims

1. Electrically conductive system comprising a substrate and an electrically conductive track adhered to the substrate wherein
• the substrate is obtained by melt processing of a composition comprising a semi-aromatic polyamide,
• the substrate comprises at least 30 wt.% of the semi-aromatic polyamide,
• the semi-aromatic polyamide comprises repeat units derived from diamines and repeat units derived from dicarboxylic acids,
• at least 10 mole% relative to the total molar amount of diamines and dicarboxylic acids consists of aromatic diamines or aromatic dicarboxylic acids,
• and the electrically conductive track is obtained by jet printing.

2. Electrically conductive system according to claim 1, wherein the electrically conductive track comprises a metal or metal alloy.

3. Electrically conductive system according to claim 2, wherein the metal is silver, gold, copper or nickel or an alloy thereof.

4. Electrically conductive system according to any of the preceding claims, wherein the electrically conductive track has a thickness of 10 nm to 100 µm.

5. Electrically conductive system according to any of the preceding claims, wherein the substrate consists of
(A) 30 - 100 wt.% of the semi-aromatic polyamide,
(B) 0 - 50 wt.% of a at least one other polymer
(C) 0 - 60 wt.% of reinforcing agents
(D) 0 - 15 wt.% of at least one additive.

6. Electrically conductive system according to claim 5, wherein the substrate contains 1 - 50 wt.% of (B) at least one other polymer, which is an aliphatic polyamide.

7. Electrically conductive system according to any of the preceding claims, wherein the semi-aromatic polyamide has a melting temperature (Tm) of at least 270 °C.

8. Electrically conductive system according to claim 7, wherein at least 30 mole% relative to the total amount of diamines and dicarboxylic acids consists of aromatic diamines or aromatic dicarboxylic acids.

9. Electrically conductive system according to claim8, wherein
• the dicarboxylic acids consist of a mixture of 5-65 mole% aliphatic dicarboxylic acid and optionally aromatic dicarboxylic acid other than terephthalic acid, and 35-95 mole % terephthalic acid;
• the diamines are aliphatic diamines and consist a mixture of 10-70 mole% of a short chain aliphatic diamine with 2-5 C atoms and 30-90 mole % of a long chain aliphatic diamine with at least 6 C atoms;
• the combined molar amount of terephthalic acid and the long chain aliphatic diamine is at least 60 mole %, relative to the total molar amount of the dicarboxylic acids and diamines.

10. Process for the production of an electrically conductive system comprising a substrate and a conductive track adhered to the substrate, comprising the steps of:
• providing a substrate obtained by melt processing of a composition comprising a semi-aromatic polyamide, wherein
∘ the substrate comprises at least 30 wt.% of the semi-aromatic polyamide,
∘ the semi-aromatic polyamide comprises repeat units derived from diamines and repeat units derived from dicarboxylic acids,
∘ at least 10 mole% relative to the total molar amount of diamines and dicarboxylic acids consists of aromatic diamines or aromatic dicarboxylic acids,
• applying a conductive track precursor on the substrate by a jet printing technique,
• sintering the conductive track precursor on the substrate at a temperature of at least 150 °C so as to obtain a conductive track on the substrate.

11. Process according to claim 10, wherein the jet printing technique is aerosol jet printing.

12. Electrically conductive system obtained by the process according to claim 10 or 11.

13. Antenna for use in a mobile device, comprising an electrically conductive system according to any of claims 1 to 9.

14. Use of an electrical conductive system according to any of claims 1 to 9 in the manufacture of electrical circuits or contacts in solar cells, transistors, Organic Light Emitting Diodes (OLED), Flexible Printed Circuits (FPC) and Radio Frequency Identification (RFID) systems.

## Patentansprüche

1. Elektrisch leitfähiges System, umfassend ein Substrat und eine elektrisch leitfähige Bahn, die an dem Substrat haftet, wobei
• das Substrat durch Schmelzverarbeitung einer Zusammensetzung, die ein halbaromatisches Polyamid umfasst, erhalten ist,
• das Substrat wenigstens 30 Gew.-% an dem halbaromatischen Polyamid umfasst,
• das halbaromatische Polyamid Wiederholungseinheiten, die von Diaminen abgeleitet sind, und Wiederholungseinheiten, die von Dicarbonsäuren abgeleitet sind, umfasst,
• wenigstens 10 mol-% bezogen auf die Gesamtmolmenge von Diaminen und Dicarbonsäuren aus aromatischen Diaminen oder aromatischen Dicarbonsäuren bestehen,
• und die elektrisch leitfähige Bahn durch Strahldruck erhalten ist.

2. Elektrisch leitfähiges System gemäß Anspruch 1, wobei die elektrisch leitfähige Bahn ein Metall oder eine Metalllegierung umfasst.

3. Elektrisch leitfähiges System gemäß Anspruch 2, wobei das Metall Silber, Gold, Kupfer oder Nickel oder eine Legierung davon ist.

4. Elektrisch leitfähiges System gemäß einem der vorstehenden Ansprüche, wobei die elektrisch leitfähige Bahn eine Dicke von 10 nm bis 100 µm aufweist.

5. Elektrisch leitfähiges System gemäß einem der vorstehenden Ansprüche, wobei das Substrat aus
(A) 30-100 Gew.-% an dem halbaromatischen Polyamid,
(B) 0-50 Gew.-% an wenigstens einem anderen Polymer,
(C) 0-60 Gew.-% an Verstärkungsmitteln,
(D) 0-15 Gew.-% an wenigstens einem Zusatzstoff
besteht.

6. Elektrisch leitfähiges System gemäß Anspruch 5, wobei das Substrat 1-50 Gew.-% an (B) wenigstens einem anderen Polymer, das ein aliphatisches Polyamid ist, enthält.

7. Elektrisch leitfähiges System gemäß einem der vorstehenden Ansprüche, wobei das halbaromatische Polyamid eine Schmelztemperatur (Tm) von wenigstens 270 °C aufweist.

8. Elektrisch leitfähiges System gemäß Anspruch 7, wobei wenigstens 30 mol-% bezogen auf die Gesamtmenge von Diaminen und Dicarbonsäuren aus aromatischen Diaminen oder aromatischen Dicarbonsäuren bestehen.

9. Elektrisch leitfähiges System gemäß Anspruch 8, wobei
• die Dicarbonsäuren aus einem Gemisch von 5-65 mol-% an aliphatischer Dicarbonsäure und gegebenenfalls aromatischer Dicarbonsäure, die von Terephthalsäure verschieden ist, und 35-95 mol-% Terephthalsäure bestehen;
• die Diamine aliphatische Diamine sind und aus einem Gemisch von 10-70 mol-% an einem kurzkettigen aliphatischen Diamin mit 2-5 C-Atomen und 30-90 mol-% an einem langkettigen aliphatischen Diamin mit wenigstens 6 C-Atomen bestehen;
• die kombinierte Molmenge von Terephthalsäure und dem langkettigen aliphatischen Diamin wenigstens 60 mol-% bezogen auf die Gesamtmolmenge der Dicarbonsäuren und Diamine beträgt.

10. Verfahren zur Herstellung eines elektrisch leitfähigen Systems, das ein Substrat und eine elektrisch leitfähige Bahn, die an dem Substrat haftet, umfasst, umfassend die Schritte:
• Bereitstellen eines Substrats, das durch Schmelzverarbeitung einer Zusammensetzung, die ein halbaromatisches Polyamid umfasst, erhalten ist, wobei
∘ das Substrat wenigstens 30 Gew.-% an dem halbaromatischen Polyamid umfasst,
∘ das halbaromatische Polyamid Wiederholungseinheiten, die von Diaminen abgeleitet sind, und Wiederholungseinheiten, die von Dicarbonsäuren abgeleitet sind, umfasst,
∘ wenigstens 10 mol-% bezogen auf die Gesamtmolmenge von Diaminen und Dicarbonsäuren aus aromatischen Diaminen oder aromatischen Dicarbonsäuren bestehen,
• Aufbringen eines leitfähige-Bahn-Vorläuferstoffs auf das Substrat durch ein Strahldruckverfahren,
• Sintern des leitfähige-Bahn-Vorläuferstoffs auf dem Substrat bei einer Temperatur von wenigstens 150 °C, um eine leitfähige Bahn auf dem Substrat zu erhalten.

11. Verfahren gemäß Anspruch 10, wobei das Strahldruckverfahren Aerosol-Strahldruck ist.

12. Elektrisch leitfähiges System, erhalten durch das Verfahren gemäß Anspruch 10 oder 11.

13. Antenne für die Verwendung in einer mobilen Vorrichtung, umfassend ein elektrisch leitfähiges System gemäß einem der Ansprüche 1 bis 9.

14. Verwendung eines elektrisch leitfähigen Systems gemäß einem der Ansprüche 1 bis 9 bei der Herstellung von elektrischen Schaltungen oder Kontakten in Solarzellen, Transistoren, organischen lichtemittierenden Dioden (OLED), flexiblen gedruckten Schaltungen (FPC) und Radiofrequenz-Identifikationssystemen (RFID).

## Revendications

1. Système électriquement conducteur comprenant un substrat et une piste électriquement conductrice collée au substrat, dans lequel
• le substrat est obtenu par traitement à l'état fondu d'une composition comprenant un polyamide semi-aromatique,
• le substrat comprend au moins 30 % en poids du polyamide semi-aromatique,
• le polyamide semi-aromatique comprend des motifs répétitifs dérivés de diamines et des motifs répétitifs dérivés d'acides dicarboxyliques,
• au moins 10 % en moles, rapporté à la quantité molaire totale de diamines et d'acides dicarboxyliques, consistent en des diamines aromatiques ou des acides dicarboxyliques aromatiques,
• et la piste électriquement conductrice est obtenue par impression par jet.

2. Système électriquement conducteur selon la revendication 1, dans lequel la piste électriquement conductrice comprend un métal ou un alliage métallique.

3. Système électriquement conducteur selon la revendication 2, dans lequel le métal est l'argent, l'or, le cuivre ou le nickel ou un alliage de ceux-ci.

4. Système électriquement conducteur selon l'une quelconque des revendications précédentes, dans lequel la piste électriquement conductrice a une épaisseur de 10 nm à 100 µm.

5. Système électriquement conducteur selon l'une quelconque des revendications précédentes, dans lequel le substrat est composé de
(A) 30-100 % en poids du polyamide semi aromatique,
(B) 0-50 % en poids d'au moins un autre polymère,
(C) 0-60 % en poids d'agents de renforcement,
(D) 0-15 % en poids d'au moins un additif.

6. Système électriquement conducteur selon la revendication 5, dans lequel le substrat contient 1-50 % en poids de (B) au moins un autre polymère, qui est un polyamide aliphatique.

7. Système électriquement conducteur selon l'une quelconque des revendications précédentes, dans lequel le polyamide semi-aromatique a une température de fusion (Tm) d'au moins 270 °C.

8. Système électriquement conducteur selon la revendication 7, dans lequel au moins 30 % en moles, rapporté à la quantité totale de diamines et d'acides dicarboxyliques, consistent en des diamines aromatiques ou des acides dicarboxyliques aromatiques.

9. Système électriquement conducteur selon la revendication 8, dans lequel
• les acides dicarboxyliques consistent en un mélange de 5-65 % en moles d'acide dicarboxylique aliphatique et éventuellement d'un acide dicarboxylique aromatique différent de l'acide téréphtalique, et 35-95 % en moles d'acide téréphtalique ;
• les diamines sont des diamines aliphatiques et consistent en un mélange de 10-70 % en moles d'une diamine aliphatique à chaîne courte avec 2-5 atomes C et 30-90 % en moles d'une diamine aliphatique à longue chaîne avec au moins 6 atomes C ;
• la quantité molaire combinée d'acide téréphtalique et de la diamine aliphatique à longue chaîne est d'au moins 60 % en moles, rapporté à la quantité molaire totale des acides dicarboxyliques et des diamines.

10. Procédé de production d'un système électriquement conducteur comprenant un substrat une piste conductrice collée au substrat, comprenant les étapes consistant à :
• se procurer un substrat obtenu par traitement à l'état fondu d'une composition comprenant un polyamide semi-aromatique, dans lequel
∘ le substrat comprend au moins 30 % en poids du polyamide semi-aromatique,
∘ le polyamide semi-aromatique comprend des motifs répétitifs dérivés de diamines et des motifs répétitifs dérivés d'acides dicarboxyliques,
∘ au moins 10 % en moles, rapporté à la quantité molaire totale de diamines et d'acides dicarboxyliques, consistent en des diamines aromatiques ou des acides dicarboxyliques aromatiques,
• appliquer un précurseur de piste conductrice sur le substrat par une technique d'impression par jet,
• fritter le précurseur de piste conductrice sur le substrat à une température d'au moins 150 °C de manière à obtenir une piste conductrice sur le substrat.

11. Procédé selon la revendication 10, dans lequel la technique d'impression par jet est une impression par jet d'aérosol.

12. Système électriquement conducteur obtenu par le procédé selon la revendication 10 ou 11.

13. Antenne à utiliser dans un dispositif mobile, comprenant un système électriquement conducteur selon l'une quelconque des revendications 1 à 9.

14. Utilisation d'un système électriquement conducteur selon l'une quelconque des revendications 1 à 9 dans la fabrication de circuits électriques ou de contacts dans des cellules solaires, des transistors, des diodes électroluminescentes organiques (OLED), des circuits imprimés souples (FPC) et des systèmes d'identification radiofréquence (RFID).
